# EUROPEAN PATENT SPECIFICATION

(11) **EP 2 200 085 B1**
(45) Date of publication and mention of the grant of the patent: **16.07.2014**
(21) Application number: 09013481.8
(22) Date of filing: 26.10.2009
(51) Int. Cl.: H01L 27/15, H01L 33/44, H01L 33/50, H01L 33/62

(54) **Light emitting diode having plurality of light emitting cells**
Licht emittierende Diode mit einer Vielzahl von lichtemittierenden Zellen
Diode électroluminescente ayant plusieurs cellules électroluminescentes

(30) Priority: 17.12.2008 KR 20080128522
(43) Date of publication of application: 23.06.2010
(73) Proprietor: SEOUL SEMICONDUCTOR CO., LTD., Geumcheon-gu Seoul 158-801 (KR)
(72) Inventor: Kal, Dae Sung, Gyeonggi-do 425-851 (KR); Kim, Dae Won, Gyeonggi-do 425-851 (KR); Seo, Won Cheol, Gyeonggi-do 425-851 (KR); Ye, Kyung Hee, Gyeonggi-do 425-851 (KR); Lee, Joo Woong, Gyeonggi-do 425-851 (KR)
(74) Representative: Stolmár, Matthias

(56) References cited:
- EP-A1- 1 914 814
- WO-A1-2007/081092
- WO-A1-2008/111693
- JP-A- 11 312 824
- US-A1- 2003 010 989

## Description

### BACKGROUND OF THE INVENTION

### FIELD OF THE INVENTION

The present disclosure relates to a light emitting diode and a method of fabricating the same. More particularly, the present disclosure relates to a light emitting diode that includes a plurality of light emitting cells, wires connecting the light emitting cells to each other, and dielectric layers for protecting the light emitting cells and the wires, and to a method of fabricating the same.

### DISCUSSION OF THE BACKGROUND

Since a GaN-based blue light emitting diode was developed, a variety of attempts have been made to improve luminescence efficiency of the light emitting diodes and a variety of structural improvements for various applications have been proposed. GaN-based blue or UV light emitting diodes are widely used for applications, such as natural color LED devices, LED traffic signal boards, white LEDs, etc., and are expected to replace white fluorescent lamps in the field of general lighting.

The light emitting diode generally emits light by application of a forward current and demands supply of a direct current. In consideration of characteristics of the light emitting diode operating by the forward current, some light emitting diodes have been developed and produced which include a plurality of light emitting cells connected in reverse parallel to each other or operated using a bridge rectifier by an alternating current power source. Further, some light emitting diodes have been developed which include a plurality of light emitting cells formed on a single substrate and connected in series and in parallel to each other to emit light with high-output and high-efficiency by a high-voltage direct current power source. In these light emitting diodes, the plural light emitting cells are formed on the single substrate and connected to each other via wires to emit light with high-output and high-efficiency by the alternating or direct current power source.

One example of the light emitting diodes including the plural light emitting cells connected to the high-voltage alternating or direct current power source is disclosed in Sakai, et. al., WO 2004/023568 A1, entitled "light-emitting device having light-emitting elements."

The light emitting cells are connected to each other by air bridge wires, thereby providing a light emitting diode which can be operated by the alternating or direct current power source.

However, interconnection between the light emitting cells via the air-bridge wires is liable to cause reliability deterioration of the wires, that is, problems such as disconnection of the wires or increase in wiring resistance due to moisture or impact from the outside. To prevent such problems, a wire connection technology based on a step-cover process is adopted. The step-cover process refers to a process of forming wires on a dielectric layer covering the light emitting cells. As such, since the wires are located on the dielectric layer, they are more stable than the air-bridge wires.

However, the wires formed by the step-cover process are also exposed to the outside and can also be disconnected by moisture or external impact. The light emitting diode having the plurality of light emitting cells includes a number of wires and cannot be operated if any one of the wires is disconnected. Furthermore, since a number of wires are used in the light emitting diode, moisture readily intrudes into the light emitting cells along the wires, thereby deteriorating luminescence efficiency of the light emitting cells.

On the other hand, when the light emitting diode is used for practical applications such as general lighting and the like, there is a need to realize a variety of colors such as white light through conversion of UV or blue light into light having longer wavelengths via fluorescent materials. Conventionally, such fluorescent materials are contained in an epoxy which covers a light emitting diode emitting short wavelength light in a package. For such a white light emitting diode, a color-conversion material layer containing the fluorescent materials is formed during a packaging process, which is independent of a process of fabricating a light emitting diode chip, so that the packaging process becomes complicated, thereby causing a high failure rate in the packaging process. Failures occurred during the packaging process cause significantly more financial damage than those produced during the process of fabricating the light emitting diode chip.

WO 2008/111693 A1 discloses a plurality of light emitting cells arranged on a single substrate. The light emitting cells comprise a lower semiconductor layer and an upper semiconductor layer thereon. An active layer is located between the upper and lower semiconductor layers. A first dielectric layer covers the light emitting cells. On the first dielectric layer wires are formed connecting the light emitting cells through openings. The first dielectric layer is covered by a second dielectric layer. The first dielectric layer and the second dielectric layer comprise the same material.

WO 2007/081092 A1 discloses a process for manufacturing a plurality of LEDs on the same substrate.

EP 1 914 814 A1 discloses that a luminescence conversion material is added to an encapsulation layer.

### SUMMARY OF THE INVENTION

The present disclosure is directed to solving the above and other problems of the related art, and an aspect of the present disclosure is to provide a light emitting diode that can prevent disconnection of wires, increase in wire resistance or performance deterioration of light emitting cells caused by moisture intrusion or external impact, and a method of fabricating the same.

Another aspect of the present disclosure is to provide a light emitting diode that includes a dielectric layer to protect wires and light emitting cells and has a reinforced bonding force between the dielectric layer and an underlayer having the dielectric layer formed thereon, and a method of fabricating the same.

A further aspect of the present disclosure is to provide a light emitting diode that includes a fluorescent material that converts a wavelength of light emitted from light emitting cells at a chip level, and a method of fabricating the same.

In accordance with an aspect, a light emitting diode includes: a plurality of light emitting cells separated from each other on a single substrate, each of the light emitting cells including a lower semiconductor layer, an upper semiconductor layer located above one region of the lower semiconductor layer and an active layer interposed between the upper and lower semiconductor layers; a first dielectric layer covering overall surfaces of the light emitting cells and having openings formed on other regions of the lower semiconductor layers and on the upper semiconductor layers; wires formed on the first dielectric layer and electrically connecting adjacent light emitting cells to each other through the openings; and a second dielectric layer covering the first dielectric layer and the wires. Here, the first and second dielectric layers are formed of the same material and the first dielectric layer is thicker than the second dielectric layer.

Since the second dielectric layer covers the wires and the light emitting cells, the wires and the light emitting cells can be protected from moisture intrusion or impact from the outside. In addition, since the first and second dielectric layers are formed of the same material, it is possible to prevent delamination of the second dielectric layer by improving a bonding force between the first and second dielectric layers. Furthermore, since the first dielectric layer is thicker than the second dielectric layer, the delamination of the second dielectric layer can be further prevented.

The first dielectric layer may have a thickness of 450nm∼1µm and the second dielectric layer may have a thickness greater than 50nm. If the first dielectric layer has a thickness less than 450nm, electrical disconnection is liable to occur between the wires and the light emitting cells. On the other hand, although the electrical disconnection between the wires and the light emitting cells can be more easily prevented with increasing thickness of the first dielectric layer, an excessive thickness of the first dielectric layer deteriorates light transmittance, thereby lowering luminescence efficiency. Accordingly, it is desirable that the first dielectric layer have a thickness not exceeding 1µm. On the contrary, if the second dielectric layer has a thickness less than 50nm, it is difficult to prevent the moisture intrusion from the exterior and to protect the light emitting cells.

Herein, the thicknesses of the first and second dielectric layers refer to thicknesses thereof when the first and second dielectric layers are formed on a flat substrate, but are not limited thereto. Generally, the thicknesses of the first and second dielectric layers in the light emitting diode in practice are thinner than the thicknesses thereof described above.

The first and second dielectric layers may be silicon oxide layers or silicon nitride layers formed by plasma enhanced chemical vapor deposition (CVD). The silicon oxide layers or silicon nitride layers may be deposited at 200-300 °C.

Particularly, the second dielectric layer may be deposited at a temperature in the range of -20∼+20% of a deposition temperature of the first dielectric layer. In the plasma enhanced CVD, the quality of a deposited layer may be significantly changed depending on the deposition temperature. Accordingly, the first and second dielectric layers may be formed at substantially similar temperatures, thereby improving the bonding force between the first and second dielectric layers.

On the other hand, the wires may have a multilayer structure that includes a lower layer contacting the first dielectric layer and an upper layer contacting the second dielectric layer. The lower layer may be a Cr layer or a Ti layer, and the upper layer may also be a Cr layer or a Ti layer. Particularly, when the first dielectric layer is the oxide layer or the nitride layer, the Cr layer or the Ti layer may be strongly bonded to the first dielectric layer. In addition, the bonding force may be further increased by heat treatment of the Cr layer or the Ti layer. Furthermore, an Au layer, an Au/Ni layer or an Au/Al layer may be interposed between the upper and lower layers.

The first and second dielectric layers may be formed of a polymer, for example, spin-on-glass (SOG) or benzocyclobutene (BCB). Since these layers are formed by spin coating, the layer can be formed by a very simple process. Further, the second dielectric layer may contain a phosphor at least in a partial region thereof. Therefore, white or various other colors can be realized at a chip level.

Alternatively, a phosphor layer may be formed on the second dielectric layer. The phosphor layer may be coated on the second dielectric layer by applying, for example, a mixture of a resin and a phosphor, or by electrophoresis.

On the other hand, transparent electrode layers may be interposed between the first dielectric layer and the upper semiconductor layers. The transparent electrode layers may be formed of indium tin oxide (ITO) or a transparent metal. When the transparent electrode layers are formed of the transparent metal, the transparent electrode layers may comprise at least one metal selected from the group consisting of Au, Ni, Pt, Al, Cr and Ti.

The wires may be electrically connected to the upper semiconductor layers via the transparent electrode layers. The transparent electrode layers may have openings through which the upper semiconductor layers are exposed, and the openings of the transparent electrode layers may be filled with the wires.

In accordance with another aspect, a method of fabricating a light emitting diode includes: forming a plurality of light emitting cells separated from each other on a single substrate, each of the light emitting cells including a lower semiconductor layer, an upper semiconductor layer located above one region of the lower semiconductor layer and an active layer interposed between the upper and lower semiconductor layers; forming a first dielectric layer covering overall surfaces of the light emitting cells and having openings formed on other regions of the lower semiconductor layers and on the upper semiconductor layers; and forming wires on the first dielectric layer to electrically connect adjacent light emitting cells to each other through the openings; and forming a second dielectric layer covering the first dielectric layer and the wires. The first and second dielectric layers are formed of the same material and the first dielectric layer is thicker than the second dielectric layer.

Accordingly, the wires and the light emitting cells can be protected from moisture or impact from the outside, and a bonding force between the first and second dielectric layers can be increased.

The first dielectric layer may have a thickness of 450nm∼1µm and the second dielectric layer may have a thickness greater than 50nm. The first and second dielectric layers may be silicon oxide layers or silicon nitride layers formed by plasma enhanced CVD. The first and second dielectric layers may be deposited at 200-300 °C. Further, the second dielectric layer may be deposited at a temperature in the range of -20∼+20% of a deposition temperature of the first dielectric layer.

On the other hand, the wires may include a lower layer contacting the first dielectric layer and an upper layer contacting the second dielectric layer. Here, the lower layer may be a Cr layer or a Ti layer, and the upper layer may also be a Cr layer or a Ti layer. Further, the wires may be heat-treated before forming the second dielectric layer to improve interfacial bonding characteristics between the wires and the first dielectric layer. Here, the wires may be heat-treated at 300∼500°C.

In some embodiments of the disclosure, the first and second dielectric layers may be formed of a polymer. In addition, the second dielectric layer may contain a phosphor.

In other embodiments of the disclosure, a phosphor layer may be formed on the second dielectric layer. The phosphor layer may be coated on the second dielectric layer by electrophoresis or by applying, for example, a mixture of a resin and a phosphor, which is obtained by dispersing the phosphor in the resin.

The forming a plurality of light emitting cells may include forming a transparent electrode layer on the upper semiconductor layer. The transparent electrode layer may be heat-treated at 500-800 °C. Further, the transparent electrode layer may be formed to have an opening through which the upper semiconductor layer is exposed, and the opening may be filled with the wires.

### BRIEF DESCRIPTION OF THE DRAWINGS

Figure 1 is a cross-sectional view of a light emitting diode in accordance with one embodiment of the present disclosure;
Figure 2 is a graph depicting a reliability testing pass rate depending on deposition temperatures of first and second dielectric layers;
Figures 3 to 9 are cross-sectional views of a method of fabricating a light emitting diode according to one embodiment of the present disclosure;
Figure 10 is a cross-sectional view of a light emitting diode in accordance with another embodiment of the present disclosure; and
Figures 11 to 13 are cross-sectional views of a method of fabricating a light emitting diode according to another embodiment of the present disclosure.

### DETAILED DESCRIPTION OF THE INVENTION

Hereinafter, exemplary embodiments of the present disclosure will be described in detail with reference to the accompanying drawings. The following embodiments are given by way of illustration to provide a thorough understanding of the invention to those skilled in the art. Hence, it should be understood that other embodiments will be evident based on the present disclosure, and that system, process or mechanical changes may be made without departing from the scope of the present disclosure. It should be noted that the drawings are not to precise scale and some of the dimensions are exaggerated for clarity of description in the drawings. In addition, like elements are denoted by like reference numerals throughout the specification and drawings.

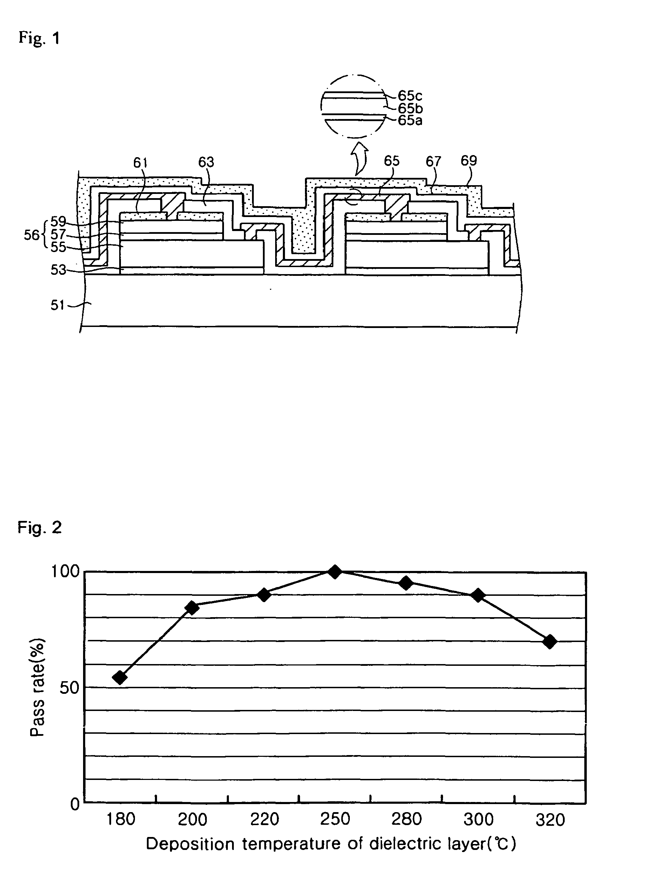

Figure 1 is a cross-sectional view of a light emitting diode in accordance with one embodiment of the present disclosure.

Referring to Figure 1, a light emitting diode according to this embodiment includes a substrate 51, a plurality of light emitting cells 56, a first dielectric layer 63, wires 65 and a second dielectric layer 67, and may further include a buffer layer 53, a transparent layer 61 and a phosphor layer 69. The substrate 51 may be a insulation substrate, for example, a sapphire substrate.

The plurality of light emitting cells 56 are separated from each other on the single substrate 51. Each of the light emitting cells 56 includes a lower semiconductor layer 55, an upper semiconductor layer 59 located above one region of the lower semiconductor layer 55 and an active layer 57 interposed between the upper and lower semiconductor layers. Here, the upper and lower semiconductor layers are n-type and p-type semiconductor layers or vice versa, respectively.

The lower semiconductor layer 55, the active layer 57, and the upper semiconductor layer 59 may be formed of GaN-based materials, that is, (Al, In, Ga)N. The composition of the active layer 57 is determined to emit light having a desired wavelength, for example, UV or blue light. The lower and upper semiconductor layers 55, 59 are formed of materials having higher band-gap energies than the active layer 57.

The lower semiconductor layer 55 and/or the upper semiconductor layer 59 may be formed in a single layer as shown in the drawing, or may be formed in a multilayer structure. Further, the active layer 57 may have a single or multi-quantum well structure.

A buffer layer 53 may be interposed between the light emitting cells 56 and the substrate 51. The buffer layer 53 may be adopted to relieve lattice mismatch between the substrate 51 and the lower semiconductor layer 55.

The first dielectric layer 63 covers the overall surfaces of the light emitting cells 56. The first dielectric layer 63 has openings formed on other regions of the lower semiconductor layers 55, that is, regions adjacent to the regions of the lower semiconductor layers 55 having the upper semiconductor layers 59, and openings formed on the upper semiconductor layers 59. The openings are separated from one another, so that lateral walls of the light emitting cells 56 are covered by the first dielectric layer 63. The first dielectric layer 63 also covers the substrate 51 on regions between the light emitting cells 56. The first dielectric layer 63 may be a silicon oxide (SiO₂) layer or a silicon nitride layer and may be formed at 200-300 °C by plasma enhanced CVD. Here, the first dielectric layer 63 may have a thickness of 450nm∼1µm. If the first dielectric layer has a thickness less than 450nm, the first dielectric layer is comparatively decreased in thickness at lower sides of the light emitting cells due to layer covering characteristics, and electrical disconnection can occur between the light emitting cells and the wires formed on the first dielectric layer. On the other hand, although the electrical disconnection between the wires and the light emitting cells can be more easily prevented with increasing thickness of the first dielectric layer, an excessive thickness of the first dielectric layer deteriorates optical transmittance, thereby reducing luminescence efficiency. Accordingly, it is desirable that the first dielectric layer have a thickness not exceeding 1µm.

On the other hand, the wires 65 are formed on the first dielectric layer 63. The wires 65 are electrically connected to the lower and upper semiconductor layers 55, 59 via the openings. Further, the wires 65 may electrically connect the lower semiconductor layers 55 and the upper semiconductor layers 59 of adjacent light emitting cells 56 to one another to constitute series arrays of the light emitting cells 56. A plurality of series arrays may be formed and connected in inverse parallel to each other to be operated by an alternating current power source. Further, a bridge rectifier (not shown) connected to the series arrays of the light emitting cells may be formed so that the light emitting cells can be driven by the bridge rectifier via the alternating current power source. The bridge rectifier may be formed by connecting the light emitting cells having the same structure as that of the light emitting cell 56 to each other via the wires 65.

Alternatively, the wires 65 may connect the lower semiconductor layers 55 or the upper semiconductor layers 59 of the adjacent light emitting cells to each other. As a result, the plurality of light emitting cells 56 may be connected to each other in series or in parallel.

The wires 65 may be formed of an electrically conductive material, for example, a metal or an impurity-doped silicon material such as polycrystalline silicon. Particularly, the wires 65 may be formed in a multilayer structure and may include a Cr or Ti lower layer 65a and a Cr or Ti upper layer 65c. Further, an Au, Au/Ni or Au/Al middle layer 65b may be interposed between the lower layer 65a and the upper layer 65c.

On the other hand, the transparent electrode layers 61 may be interposed between the upper semiconductor layers 59 and the first dielectric layer 63. The transparent electrode layers 61 are exposed through the openings formed on the upper semiconductor layers 59. The transparent electrode layers 61 allow penetration of light generated from the active layer 57 and dispersedly supply a current to the upper semiconductor layers 59. The wires 65 may contact the transparent electrode layers 61 exposed through the openings to be electrically connected to the upper semiconductor layers 55. Further, the transparent electrode layers 61 may have openings through which the upper semiconductor layers 59 are exposed, and the wires 65 fill in the openings in the transparent electrode layers 61.

The second dielectric layer 67 covers the wires 65 and the first dielectric layer 63. The second dielectric layer 67 prevents the wires 65 from being contaminated by moisture and the like, and also prevents the wires 65 and the light emitting cells 56 from being damaged by external impact.

The second dielectric layer 67 may be formed of silicon oxide (SiO₂) or silicon nitride, which is the same material as that of the first dielectric layer 63. As in the first dielectric layer, the second dielectric layer 67 may be formed at 200-300 °C by plasma enhanced CVD. When the first dielectric layer 63 is formed by plasma enhanced CVD, the second dielectric layer 67 may be formed at a temperature in the range of -20∼+20% of the deposition temperature of the first dielectric layer 63. Advantageously, the second dielectric layer 67 is formed at the same deposition temperature as that of the first dielectric layer 63.

This can be corroborated from Figure 2. Figure 2 is a graph depicting a reliability testing pass rate of samples depending on deposition temperature of first and second dielectric layers. For the reliability testing, the samples were prepared by depositing a silicon oxide layer as the first dielectric layer 63 at 250 °C and depositing another silicon oxide layer as the second dielectric layer 67 while changing the deposition temperature. The reliability testing was performed for 1000 hours. 20 samples were prepared for testing at each deposition temperature of the second dielectric layer and each of the samples was tested under humid conditions. Referring to Figure 2, when the second dielectric layer was deposited at a temperature in the range of -20∼+20% of the deposition temperature (250°C) of the first dielectric layer 63, the sample exhibited superior reliability. On the other hand, when the deposition temperature of the second dielectric layer exceeded this range, the reliability was rapidly decreased. Further, when the first and second dielectric layers were deposited at the same temperature, the success rate was 100%, which is the highest reliability.

On the other hand, the second dielectric layer 67 is thinner than the first dielectric layer 63 and may have a thickness of 50nm or more. Since the second dielectric layer 67 is thinner than the first dielectric layer 63, the second dielectric layer can be prevented from being delaminated from the first dielectric layer. When the second dielectric layer 67 is thinner than 50nm, it is difficult to protect the wires and the light emitting cells from external impact or moisture intrusion.

The phosphor layer 69 may contain a phosphor dispersed in a resin or may be deposited by electrophoresis. The phosphor layer 69 covers the second dielectric layer 67 and converts the wavelength of light emitted from the light emitting cells 56.

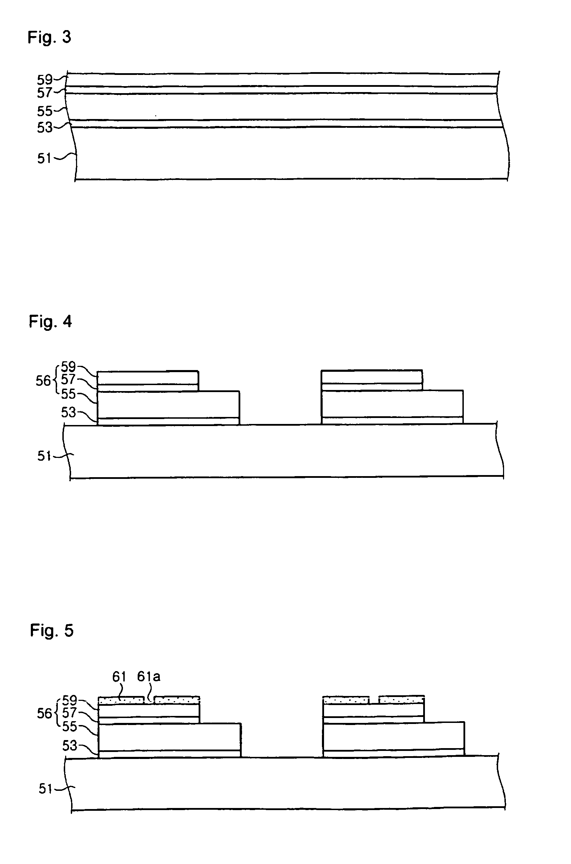

Figures 3 to 9 are cross-sectional views of a method of fabricating a light emitting diode according to one embodiment of the present disclosure.

Referring to Figure 3, a lower semiconductor layer 55, an active layer 57, and an upper semiconductor layer 59 are formed on a substrate 51. Further, a buffer layer 53 may be formed on the substrate 51 before the formation of the lower semiconductor layer 55.

A material for the substrate 51 may include, but is not limited to, sapphire (Al₂O₃), silicon carbide (SiC), zinc oxide (ZnO), silicon (Si), gallium arsenide (GaAs), gallium phosphide (GaP), lithium-alumina (LiAl₂O₃), boron nitride (BN), aluminum nitride (AlN), or gallium nitride (GaN), and may be selected from other materials depending on materials of the semiconductor layer formed thereon.

The buffer layer 53 is formed to relieve lattice mismatch between the substrate 51 and the semiconductor layer 55, and may be formed of, for example, gallium nitride (GaN) or aluminum nitride (AlN). If the substrate 51 is an electrically conductive substrate, the buffer layer 53 may be formed of a insulating or semi-insulating layer and may be formed of AlN or semi-insulating GaN.

The lower semiconductor layer 55, the active layer 57, and the upper semiconductor layer 59 may be formed of GaN-based materials, that is, (Al, In, Ga)N. The lower and upper semiconductor layers 55, 59 and the active layer 57 may be intermittently or continuously grown by metal-organic chemical vapor deposition (MOCVD), molecular beam epitaxy, hydride vapor phase epitaxy (HVPE) or the like.

Here, the upper and lower semiconductor layers are n-type and p-type semiconductor layers or vice versa, respectively. In a GaN-based compound semiconductor layer, the n-type semiconductor layer may be formed by doping an impurity, for example, Si, and the p-type semiconductor layer may be formed by doping an impurity, for example, Mg.

Referring to Figure 4, light emitting cells 56 are formed to be separated from each other by patterning the upper semiconductor layer 59, the active layer 57, and the lower semiconductor layer 55. In this process, the upper semiconductor layer 59 is located on one region of the lower semiconductor layer 55 and the other region of the lower semiconductor layer 55 is exposed. On the other hand, the buffer layer 53 between the light emitting cells may be removed to expose the substrate 51.

Referring to Figure 5, a transparent electrode layer 61 may be formed on the upper semiconductor layer 59 of the light emitting cell 56. The transparent electrode layer 61 may be formed of a metal oxide, such as ITO, or a transparent metal. For the transparent metal, the transparent electrode layer 61 may comprise at least one selected from the group consisting of Au, Ni, Pt, Al, Cr, Ti, and alloys thereof.

The transparent electrode layer 61 may have an opening 61a through which the upper semiconductor layer 59 is exposed. Although the transparent electrode layer 61 may be formed by deposition on the light emitting cells 56, the transparent electrode layer 61 may be formed on the upper semiconductor layer 59 before the formation of the light emitting cells 56 and then patterned before patterning the upper semiconductor layer 59.

The transparent electrode layer 61 may be heat-treated at 500∼800°C for ohmic contact with the upper semiconductor layer 59.

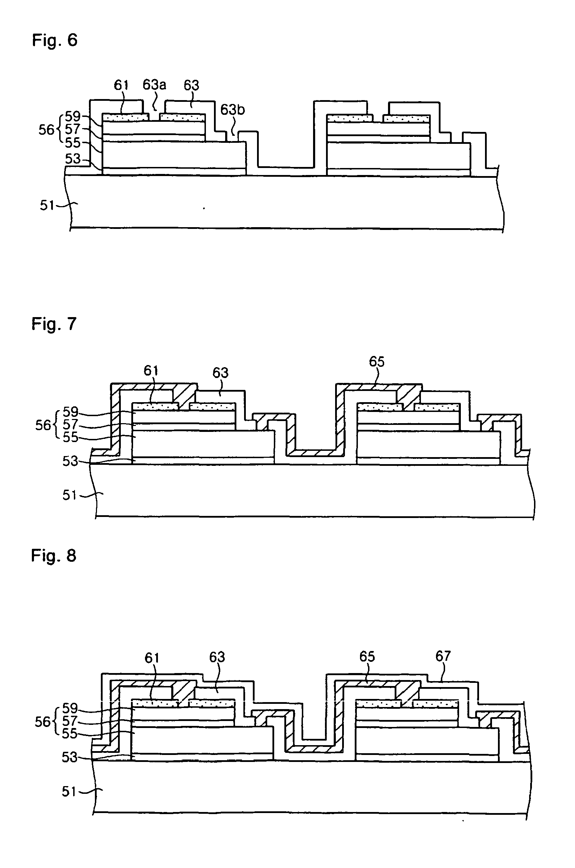

Referring to Figure 6, a first dielectric layer 63 is formed over the substrate 51 having the light emitting cells 56. The first dielectric layer 63 covers lateral walls and upper surfaces of the light emitting cells 56, and upper surfaces of regions of the substrate 51 in regions between the light emitting cells 56. The first dielectric layer 63 may be, for example, a silicon oxide layer or a silicon nitride layer formed by plasma enhanced CVD. In this case, the first dielectric layer 63 may be deposited at 200-300 °C and have a thickness of 450nm∼1µm.

Then, the first dielectric layer 63 is patterned to form openings 63a on the upper semiconductor layers 59 and openings 63b on the other regions of the lower semiconductor layers 55. When the transparent electrode layers 61 are formed, the transparent electrode layers 61 are exposed through the openings 63a. Further, when the transparent electrode layers 61 have openings 61 a, the openings 63a of the first dielectric layer 63 expose the openings 61 a of the transparent electrode layers 61.

Referring to Figure 7, wires 65 are formed on the first dielectric layer 63 which has the openings 63a. The wires 65 are electrically connected to the lower semiconductor layers 55 and the upper semiconductor layers 59 through the openings 63a, 63b and electrically connect the adjacent light emitting cells 56 to each other.

The wires 65 may be formed by plating, general electron beam deposition, CVD or physical vapor deposition (PVD).

On the other hand, the wires 65 may be formed of an electrically conductive material, for example, a metal or an impurity-doped silicon material such as polycrystal silicon. Particularly, the wires 65 may be formed in a multilayer structure and may include, for example, a Cr or Ti lower layer 65a and a Cr or Ti upper layer 65c (see Figure 1). Further, an Au, Au/Ni or Au/Al middle layer 65b (see Figure 1) may be interposed between the lower layer 65a and the upper layer 65c. The wires 65 may be heat-treated at 300-500 °C to improve the bonding force between the wires 65 and the first dielectric layer 63.

Referring to Figure 8, a second dielectric layer 67 is formed over the substrate 51 having the wires 65 formed thereon. The second dielectric layer 67 covers the wires 65 and the first dielectric layer 63. The second dielectric layer 67 may be formed of silicon oxide (SiO₂) or silicon nitride, which is the same material as that of the first dielectric layer 63, and formed at 200-300 °C by plasma enhanced CVD. Particularly, the second dielectric layer 67 may be formed at a temperature in the range of -20∼+20% of the deposition temperature of the first dielectric layer 63.

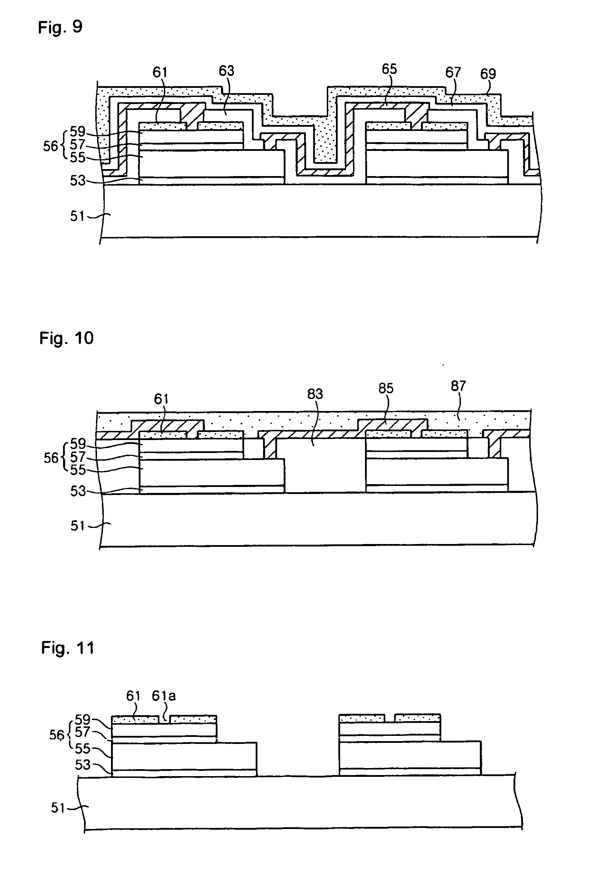

Referring to Figure 9, a phosphor layer 69 may be formed on the second dielectric layer 67. The phosphor layer 69 may be coated on the second dielectric layer 67 by applying a mixture of a resin and a phosphor, which is prepared by dispersing the phosphor in the resin, or by electrophoresis. As a result, a light emitting diode having a fluorescent material is prepared at a chip level.

Figure 10 is a cross-sectional view of a light emitting diode in accordance with another embodiment of the present disclosure. In this light emitting diode, a polymer is employed for first and second dielectric layers.

Referring to Figure 10, the light emitting diode includes a substrate 51, a plurality of light emitting cells 56, a first dielectric layer 83, wires 85, and a second dielectric layer 87, and may further include a buffer layer 53 and a transparent layer 61. The substrate 51, the light emitting cells 56, and the transparent electrode layer 61 are the same as those of the above embodiment, and detailed descriptions thereof will be omitted herein.

The first dielectric layer 83 is formed of SOG, BCG or other transparent polymers to fill in spaces between the light emitting cells 56. The first dielectric layer 83 covers other regions of the lower semiconductor layers 55. In this case, the first dielectric layer 83 has openings through which the lower semiconductor layers 55 are exposed. Further, the first dielectric layer 83 exposes the upper semiconductor layers 59 or the transparent electrode layers 61. Lateral walls of the light emitting cells 56 are covered by the first insulating layer 83.

The wires 85 are formed on the first dielectric layer 83 and electrically connected to the lower and upper semiconductor layers 55, 59. The wires 85 are electrically connected to the lower and upper semiconductor layers 55, 59 via the openings. Further, the wires 85 may electrically connect the lower semiconductor layers 55 and the upper semiconductor layers 59 of adjacent light emitting cells 56 to one another to constitute series arrays of the light emitting cells 56. A plurality of series arrays may be formed and connected in inverse parallel to each other to be operated by an alternating current power source. Further, a bridge rectifier (not shown) connected to the series arrays of the light emitting cells may be formed so that the light emitting cells can be driven by the bridge rectifier via the alternating current power source. The bridge rectifier may be formed by connecting the light emitting cells having the same structure as that of the light emitting cell 56 to each other via the wires 85.

Alternatively, the wires 85 may connect the lower semiconductor layers 55 or the upper semiconductor layers 59 of the adjacent light emitting cells to each other. As a result, the plurality of light emitting cells 56 may be connected to each other in series or in parallel.

The wires 85 may be formed of an electrically conductive material, for example, a metal or an impurity-doped silicon material such as polycrystal silicon. Particularly, the wires 85 may be formed in a multilayer structure.

The second dielectric layer 87 covers the wires 85 and the first dielectric layer 83. The second dielectric layer 87 is formed of the same polymer as that of the first dielectric layer 83. Accordingly, a bonding force between the first dielectric layer 83 and the second dielectric layer 87 is increased. Further, the second dielectric layer 87 may be thinner than the first dielectric layer 83, which fills in the spaces between the light emitting cells 56.

On the other hand, the second dielectric layer 87 may contain a phosphor. Accordingly, it is possible to provide a light emitting diode capable of converting wavelengths at a chip level.

In this embodiment, since the first dielectric layer is formed of the polymer, the wires 85 and the second dielectric layer 87 can be formed on the relatively flat first dielectric layer, thereby further improving reliability of the wires.

Figures 11 to 13 are cross-sectional views of a method of fabricating a light emitting diode according to another embodiment of the present disclosure.

Referring to Figure 11, a plurality of light emitting cells 56 separated from each other and a transparent electrode layer 61 are formed on a single substrate 51, as described above in Figures 3 to 5. Each of the light emitting cells 56 includes a lower semiconductor layer 55, an active layer 57, and an upper semiconductor layer 59. The transparent electrode layer 61 may have openings 61 a through which the upper semiconductor layers 59 are exposed.

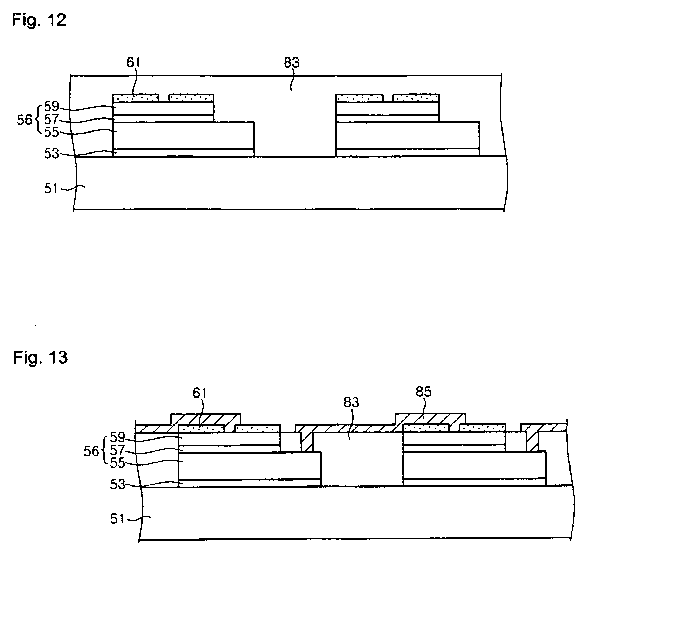

Referring to Figure 12, a first dielectric layer 83 is formed to cover the light emitting cells 56 and the transparent electrode layer 61. The first dielectric layer 83 is formed of a polymer and fills in spaces between the light emitting cells 56 while covering the overall surfaces of the light emitting cells 56.

Referring to Figure 13, the first dielectric layer 83 is partially removed by etching to expose the transparent electrode layer 61. Then, wires 85 are formed on the first dielectric layer 83 and the light emitting cells 56. The wires 85 may be formed of any material described above in Figure 7.

Then, a second dielectric layer 87 (see Figure 10) is formed to cover the wires 85 and the first dielectric layer 83. The second dielectric layer 87 is formed of the same polymer as that of the first dielectric layer 83 and may contain a phosphor.

On the other hand, when the second dielectric layer is thicker than the first dielectric layer, optical transmittance is deteriorated and the first or second dielectric layer can be delaminated from the light emitting cells by external impact. Accordingly, it is desirable that the second dielectric layer 87 be thinner than the first dielectric layer 83 (herein, the thickness of the first dielectric layer 83 in the space between the light emitting cells).

In this embodiment, the phosphor is described as being contained in the second dielectric layer 87, but may also be contained in the first dielectric layer 83. Further, a separate phosphor layer may be additionally formed on the second dielectric layer 87.

According to the embodiments of the disclosure, first and second dielectric layers are formed of the same material and the first dielectric layer is formed thicker than the second dielectric layer, thereby improving the bonding force between the first and second dielectric layers while preventing delamination of the second dielectric layer. Further, the second dielectric layer covers the wires and the light emitting cells, thereby preventing moisture from entering the light emitting diode, while protecting the wires and the light emitting cells from external impact.

Additionally, Cr layers or Ti layers exhibiting a high bonding force with respect to a dielectric layer are provided as the lower layer and the upper layer of the wires, thereby further improving the bonding force between the wires and the dielectric layers while preventing delamination of the second dielectric layer.

Furthermore, a phosphor is contained in the second dielectric layer or a phosphor layer is formed on the second dielectric layer to realize white and various other colors at a chip level, thereby enabling simplification of a packaging process.

The various embodiments described above can be combined to provide further embodiments. All of the patents, patent application publications, patent applications, foreign patents, foreign patent applications and non-patent publications referred to in this specification and/or listed in the Application Data Sheet are incorporated herein by reference, in their entirety. Aspects of the embodiments can be modified, if necessary to employ concepts of the various patents, applications and publications to provide yet further embodiments.

These and other changes can be made to the embodiments in light of the above-detailed description. In general, in the following claims, the terms used should not be construed to limit the claims to the specific embodiments disclosed in the specification, but should be construed to include all possible embodiments along with the scope of the claims.

## Claims

1. A light emitting diode comprising:
a plurality of light emitting cells (56) separated from each other on a single substrate (51), each of the light emitting cells (56) comprising a lower semiconductor layer (55), an upper semiconductor layer (59) located above one region of the lower semiconductor layer (55) and an active layer (57) interposed between the upper and lower semiconductor layers (55, 59),
a first dielectric (63) layer covering overall surfaces of the light emitting cells (59) and having openings formed on other regions of the lower semiconductor layers (55) and on the upper semiconductor layers (59),
wires (65) formed on the first dielectric layer (63) and electrically connecting adjacent light emitting cells (56) to each other through the openings; and
a second dielectric layer (67) covering the first dielectric layer (63) and the wires (65),
wherein the first and second dielectric layers (63, 67) are formed of the same material,
**characterized in that** the first dielectric layer (63) is thicker than the second dielectric layer (67)., wherein the first dielectric layer (63) has a thickness of 450nm∼1µm and the second dielectric layer (67) has a thickness greater than 50nm, wherein the first and second dielectric layers (63, 67) are formed of a polymer and the second dielectric layer (67) contains a phosphor at least in a partial region.

2. The light emitting diode according to claim 1, wherein the wires have a multilayer structure that includes a lower layer (65a) contacting the first dielectric layer (63) and an upper layer (65c) contacting the second dielectric layer (67), the upper and lower layers (65c, 65a) being Cr layers or Ti layers.

3. The light emitting diode according to claim 2, further comprising an Au layer, an Au/Ni layer or an Au/Al between the upper and lower layers (65c, 65a).

4. The light emitting diode according to claim 1, further comprising: a phosphor layer on the second dielectric layer (67).

5. The light emitting diode according to claim 1, further comprising: transparent electrode layers (61) between the first dielectric layer (63) and the upper semiconductor layers (67).

6. The light emitting diode according to claim 5, wherein the transparent electrode layers (61) are formed of ITO.

7. The light emitting diode according to claim 5, wherein the transparent electrode layers (61) comprise at least one metal selected from the group consisting of Au, Ni, Pt, Al, Cr and Ti.

8. The light emitting diode according to claim 5, wherein the transparent electrode layers (61) have openings through which the upper semiconductor layers (59) are exposed, the openings being filled with the wires (65).

## Patentansprüche

1. Lichtemittierende Diode, umfassend:
eine Vielzahl lichtemittierender Zellen (56), die auf einem einzelnen Substrat (51) voneinander getrennt sind, wobei jede der lichtemittierenden Zellen (56), eine untere Halbleiterschicht (55), eine auf einem Bereich der unteren Halbleiterschicht (55) angeordnete obere Halbleiterschicht (59) und eine zwischen der oberen und unteren Halbleiterschicht (55, 59) angeordnete aktive Schicht umfasst,
eine erste dielektrische Schicht (63), die die gesamten Flächen der lichtemittierenden Zellen (59) bedeckt und auf anderen Bereichen der unteren Halbleiterschichten (55) und auf den oberen Halbleiterschichten (59) ausgebildete Öffnungen aufweist,
Drähte (65), die auf der ersten dielektrischen Schicht (63) ausgebildet sind und die benachbarten lichtemittierenden Zellen (56) durch die Öffnungen hindurch miteinander elektrisch verbinden; und
eine zweite dielektrische Schicht (67), die die erste dielektrische Schicht (63) und die Drähte (65) bedeckt,
wobei die erste und zweite dielektrische Schicht (63, 67) aus demselben Material gebildet sind,
dadurch charakterisiert, dass die erste dielektrische Schicht (63) dicker als die zweite dielektrische Schicht (67) ist, wobei die erste dielektrische Schicht (63) eine Dicke von 450 nm ∼ 1 µm aufweist und die zweite dielektrische Schicht (67) eine Dicke von mehr als 50 nm aufweist, und wobei die erste und die zweite dielektrische Schicht (63, 67) aus einem Polymer gebildet sind und die zweite dielektrische Schicht (67) wenigstens in einem Teilbereich Phosphor enthält.

2. Lichtemittierende Diode nach Anspruch 1, wobei die Drähte eine mehrschichtige Struktur aufweisen, umfassend eine untere Schicht (65a), die in Kontakt mit der ersten dielektrischen Schicht (63) ist, und eine obere Schicht (65c), die in Kontakt mit der zweiten dielektrischen Schicht (67) ist, wobei die obere und die untere Schicht (65c, 65a) Cr-Schichten oder Ti-Schichten sind.

3. Lichtemittierende Diode nach Anspruch 2, weiterhin umfassend eine Au-Schicht, eine Au/Ni-Schicht oder eine Au/Al-Schicht zwischen der oberen und unteren Schicht (65c, 65a).

4. Lichtemittierende Diode nach Anspruch 1, weiterhin umfassend: eine Phosphorschicht auf der zweiten dielektrischen Schicht (67).

5. Lichtemittierende Diode nach Anspruch 1, weiterhin umfassend: transparente Elektrodenschichten (61) zwischen der ersten dielektrischen Schicht (63) und den oberen Halbleiterschichten (59).

6. Lichtemittierende Diode nach Anspruch 5, wobei die transparenten Elektrodenschichten (61) aus ITO gebildet sind.

7. Lichtemittierende Diode nach Anspruch 5, wobei die transparenten Elektrodenschichten (61) wenigstens ein Metall, ausgewählt aus der Gruppe, bestehend aus Au, Ni, Pt, Al, Cr und Ti umfassen.

8. Lichtemittierende Diode nach Anspruch 5, wobei die transparenten Elektrodenschichten (61) Öffnungen aufweisen, durch die hindurch die oberen Halbleiterschichten (59) freigelegt sind, wobei die Öffnungen mit den Drähten (65) gefüllt sind.

## Revendications

1. Diode électroluminescente comprenant :
une pluralité de cellules électroluminescentes (56) séparées les unes des autres sur un substrat unique (51), chacune des cellules électroluminescentes (56) comprenant une couche de semi-conducteur inférieure (55), une couche de semi-conducteur supérieure (59) située au-dessus d'une région de la couche de semi-conducteur inférieure (55) et une couche active (57) interposée entre les couches de semi-conducteur supérieure et inférieure (55, 59),
une première couche diélectrique (63) recouvrant des surfaces globales des cellules électroluminescentes (59) et ayant des ouvertures formées sur d'autres régions des couches de semi-conducteur inférieures (55) et sur les couches de semi-conducteur supérieures (59),
des fils électriques (65) formés sur la première couche diélectrique (63) et connectant électriquement des cellules électroluminescentes adjacentes (56) les unes aux autres à travers les ouvertures ; et
une seconde couche diélectrique (67) recouvrant la première couche diélectrique (63) et les fils électriques (65),
dans laquelle les première et seconde couches diélectriques (63, 67) sont formées du même matériau,
**caractérisée en ce que** la première couche diélectrique (63) est plus épaisse que la seconde couche diélectrique (67), dans laquelle la première couche diélectrique (63) a une épaisseur de 450 nm∼1 µm et la seconde couche diélectrique (67) a une épaisseur supérieure à 50 nm, dans laquelle les première et seconde couches diélectriques (63, 67) sont formées d'un polymère et la seconde couche diélectrique (67) contient un phosphore au moins dans une région partielle.

2. Diode électroluminescente selon la revendication 1, dans laquelle les fils électriques ont une structure multicouches qui inclut une couche inférieure (65a) venant en contact avec la première couche diélectrique (63) et une couche supérieure (65c) venant en contact avec la seconde couche diélectrique (67), les couches supérieure et inférieure (65c, 65a) étant des couches de Cr ou des couches de Ti.

3. Diode électroluminescente selon la revendication 2, comprenant en outre une couche d'Au, une couche d'Au/Ni ou une d'Au/Al entre les couches supérieure et inférieure (65c, 65a).

4. Diode électroluminescente selon la revendication 1, comprenant en outre : une couche de phosphore sur la seconde couche diélectrique (67).

5. Diode électroluminescente selon la revendication 1, comprenant en outre : des couches d'électrode transparentes (61) entre la première couche diélectrique (63) et les couches de semi-conducteur supérieures (67).

6. Diode électroluminescente selon la revendication 5, dans laquelle les couches d'électrode transparentes (61) sont formées d'ITO.

7. Diode électroluminescente selon la revendication 5, dans laquelle les couches d'électrode transparentes (61) comprennent au moins un métal sélectionné parmi le groupe constitué d'Au, Ni, Pt, Al, Cr et Ti.

8. Diode électroluminescente selon la revendication 5, dans laquelle les couches d'électrode transparentes (61) ont des ouvertures à travers lesquelles les couches de semi-conducteur supérieures (59) sont exposées, les ouvertures étant remplies des fils électriques (65).
